# EUROPÄISCHE PATENTSCHRIFT

(11) **EP 0 437 559 B1**
(45) Veröffentlichungstag und Bekanntmachung des Hinweises auf die Patenterteilung: **29.09.1993**
(21) Anmeldenummer: 90910096.8
(22) Anmeldetag: 07.07.1990
(51) Int. Cl.: F02D 41/22

(54) **VERFAHREN UND VORRICHTUNG ZUR STEUERUNG UND/ODER REGELUNG DER MOTORLEISTUNG EINER BRENNKRAFTMASCHINE EINES KRAFTFAHRZEUGS**
PROCESS AND DEVICE FOR CONTROLLING AND/OR REGULATING THE OUTPUT OF AN INTERNAL COMBUSTION ENGINE IN A MOTOR VEHICLE
PROCEDE ET DISPOSITIF DE COMMANDE ET/OU DE REGULATION DE LA PUISSANCE DU MOTEUR A COMBUSTION INTERNE D'UN VEHICULE

(30) Priorität: 04.08.1989 DE 3925881
(43) Veröffentlichungstag der Anmeldung: 24.07.1991
(73) Patentinhaber: ROBERT BOSCH GMBH, 70442 Stuttgart (DE)
(72) Erfinder: KRAMPE, Wolfgang, D-7253 Renningen 2 (DE); LIEBEROTH-LEDEN, Bernd, D-7250 Leonberg 7 (DE)
(86) Internationale Anmeldenummer: DE9000506
(87) Internationale Veröffentlichungsnummer: WO9102147

(56) Entgegenhaltungen:
- EP-A- 326 693
- EP-A- 0 170 018
- DE-A- 3 621 937
- DE-A- 3 808 382
- Patent Abstracts of Japan, Band 9, Nr. 209 (M-407), 27. August 1985, & JP-A-6009238 (MAZDA) 19. April 1990

## Beschreibung

### Stand der Technik

Die Erfindung bezieht sich auf ein Verfahren und eine Vorrichtung zur Steuerung und/oder Regelung der Motorleistung einer Brennkraftmaschine eines Kraftfahrzeugs.

Ein derartiges Verfahren bzw. eine derartige Vorrichtung ist aus der DE-OS 28 39 467 bekannt. Dort ist ein elektronisches Gaspedalsystem beschrieben, das durch einen Vergleich von Fahrpedal- und Stellgliedstellung einen sicherheitskritischen Betriebszustand des Systems erkennt, wenn sich z.B. das Stellglied in seiner Gas- und das Fahrpedal in der Leerlaufstellung befindet. Ein solcher Betriebszustand kann bei verklemmtem Stellglied auftreten. Bei erkanntem Sicherheitsfall wird entsprechend der DE-OS 28 39 467 die Drehzahl bzw. Leistung der Brennkraftmaschine reduziert, indem ein die Drehzahl der Brennkraftmaschine beeinflussendes Aggregat in drehzahlsenkendem Sinne angesteuert wird. Insbesondere wird dabei die Kraftstoffzufuhr zur Brennkraftmaschine unterbrochen. Nachteil einer derartigen Vorgehensweise ist, daß ein Ausfall dieser Sicherheitsfunktion nicht erkennbar ist und im Sicherheitsfall bei offenstehendem Leistungsstellglied trotz aktiver Sicherheitsfunktion das elektronische Gaspedalsystem das Kraftfahrzeug unkontrolliert beschleunigen kann.

Die nachveröffentlichte europäische Patentanmeldung 326 693 beschreibt die Funktionsüberprüfung eines Sicherheitsabschaltventils im Schubbetrieb. Dazu wird im Schubbetrieb, bei Leerlaufstellung des Fahrpedals ein Einspritzsignal erzeugt, welches letztendlich zur Einspritzung von Kraftstoff führt. Nachdem die Kraftstoffeinspritzung erkannt wurde, wird das Sicherheitsabschaltventil aktiviert. Bei korrekter Funktion des Ventils muß dann eine Unterbrechung der Kraftstoffzufuhr erkennbar sein. Demgegenüber wird gemäß der vorliegenden Anmeldung keine Einspritzung von Kraftstoff zur Überprüfung der Sicherheitsfunktion vorgenommen, sondern die Signalgrundlage für die Kraftstoffzumessung (Kraftstoffabschaltung) im Schubbetrieb für eine vorgegebene Zeit- dauer verändert.

Aus der EP-A 1 30 341 ist ein Verfahren zur Steuerung der Brennkraftmaschine im Schubbetrieb bekannt, wobei bei erkanntem Schubbetrieb die Kraftstoffzufuhr oberhalb einer zeitlich veränderbaren Grenzdrehzahl abgeschaltet wird. Dabei liegt Schubbetrieb dann vor, wenn sich Stellglied oder Fahrpedal in Leerlaufstellung befinden.

Der Erfindung liegt somit die Aufgabe zugrunde, bei einer Sicherheitsfunktion der obengenannten Art eine Überprüfung der Verfügungsbereitschaft dieser Sicherheitsfunktion zur Verbesserung der Betriebssicherheit eines Kraftfahrzeugs vorzunehmen. Diese Aufgabe wird durch die in den Ansprüchen 1 und 6 aufgeführten Merkmale gelöst.

Die EP-A 170 018 beschreibt die Überprüfung von Stellgliedern im Schubbetrieb der Brennkraftmaschine, wobei während dieser Betriebsphase das Stellglied mit einer vorgegebenen Testansteuerung beaufschlagt wird und anhand eines Lastwertes die korrekte Funktion des Stellgliedes erkannt wird, wenn die Lastsignaländerung mit der Ansteuersignaländerung korreliert.

### Vorteile der Erfindung

Die erfindungsgemäße Lösung hat den Vorteil, daß die Sicherheitsfunktion ständig, auch während des Betriebs des Kraftfahrzeugs, auf ihre einwandfreie Funktion hin überprüft werden kann, ein Ausfall der Sicherheitsfunktion rechtzeitig erkennbar ist und so bei einem tatsächlich auftretenden Sicherheitsfall auf eine funktionierende Sicherheitsfunktion zurückgegriffen werden kann.

Ein weiterer Vorteil ist darin zu sehen, daß die Überprüfung der Sicherheitsfunktion, d.h. das Auslösen der Sicherheitsfunktion zu Testzwecken, im Schubbetrieb der Brennkraftmaschine, weder Fahrbarkeit, noch Abgas beeinträchtigt und vom Fahrer nicht bemerkt wird.

Weitere Vorteile ergeben sich aus der Beschreibung der nachfolgenden Ausführungsbeispiele in Verbindung mit den Unteransprüchen.

### Zeichnung

Die Erfindung wird nachstehend anhand der in den Zeichnungen dargestellten Ausführungsbeispielen erläutert. Dabei zeigt Figur 1 ein aus Übersichtlichkeitsgründen gewähltes Blockschaltbild eines Motorsteuerungssystems, Figur 2 beschreibt ein Flußdiagramm zur Verdeutlichung der erfindungsgemäßen Vorgehensweise, während Figur 3 ein Zeitdiagramm der bei Ausführung des erfindungsgemäßen Verfahrens auftretenden Signalverläufe darstellt, Figur 4 beschreibt weitere, vorteilhafte Ausführungsbeispiele des Erfindungsgedankens.

### Beschreibung des Ausführungsbeispieles

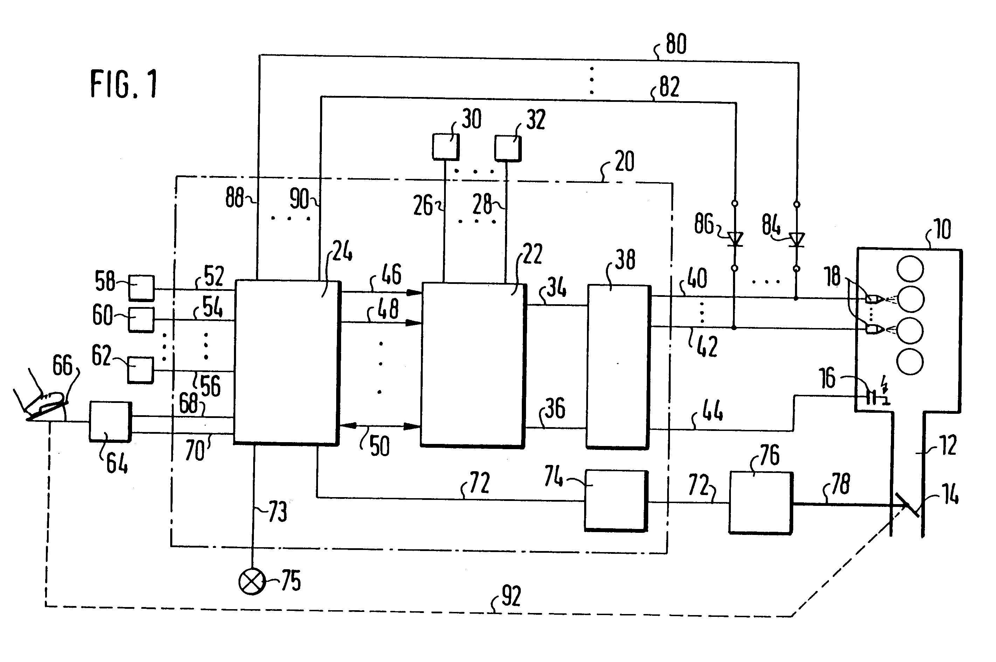

Figur 1 zeigt eine symbolisch dargestellte Brennkraftmaschine 10 mit einem Ansaugrohr 12, indem sich eine Drosselklappe 14 befindet. Ferner umfaßt die Brennkraftmaschine eine Zündungseinrichtung 16 sowie wenigstens eine Kraftstoffzumeßeinrichtung 18. Selbstverständlich kann die Einspritzanlage als zylinderspezifische Einspritzung als auch als Zentraleinspritzung ausgebildet sein und die Brennkraftmaschine über einen die Drosselklappe überbrückenden Bypass zur Regelung der Leerlaufdrehzahl verfügen.

Ferner ist in Figur 1 ein strichpunktiert dargestelltes Motorsteuerungssystem 20 gezeigt. Dieses besteht im wesentlichen aus zwei Einheiten, einer Motorsteuerungseinheit 22, mit deren Hilfe die Motorparameter Kraftstoffzumessung, Zündung und/oder Leerlaufdrehzahl gesteuert werden können sowie einer elektronischen Motorleistungssteuerung 24, die zur fahrerwunschabhängigen Steuerung der Drosselklappe 14 als auch zur Einstellung der Leerlaufdrehzahl Verwendung findet.

Die Motorsteuerungseinheit 22 ist mit ihren Eingangsleitungen 26 bis 28 mit Meßanordnungen 30 bis 32 der Brennkraftmaschine und des Kraftfahrzeugs zur Messung von Betriebskenndaten verbunden. Diese in der Figur 1 nicht vollständig dargestellten Meßanordnungen führen der Motorsteuerungseinheit 22 z. B. Drehzahlsignale, Meßwerte für die Luftmasse bzw. -menge, Motortemperatur, Abgaszusammensetzung und/oder ähnliche aus dem Stand der Technik bekannte Betriebskenndaten zu. Die Motorsteuerungseinheit 22 berechnet aus diesen Eingangsgrößen die zuzumessende Kraftstoffmenge und/oder den geeigneten Zündzeitpunkt und/oder die Stellung eines Leerlaufstellgliedes. In Figur 1 ist die Motorsteuerungseinheit 22 symbolisch über ihre Ausgangsleitungen 34 und 36 mit einer Treiberstufe 38 verbunden, die über ihre Verbindungsleitungen 40 bis 42 die Kraftstoffzumeßeinrichtungen 18 entsprechend der berechneten, zuzumessenden Kraftstoffmenge steuern sowie über ihre Ausgangsleitungen 44 mit der Zündungseinrichtung 16 verbunden ist. Durch die Verbindungsleitungen 40 bis 42 (bzw. durch die weiter unten beschriebenen Rückmeldeleitungen 80 bis 82) soll ausgedrückt werden, daß der erfindungsgemäße Gedanken sowohl bei Zentraleinspritzanlage mit einer Verbindungsleitung als auch bei zylinderspezifischen Einspritzanlagen mit zwei oder mehr Zylindern (und entsprechender Leitungsanzahl) Anwendung findet. Ferner wird der Motorsteuerungseinheit 22 über die Verbindungsleitungen 46, 48 und 50, die die Motorsteuerungseinheit 22 mit der elektronischen Motorleistungssteuerung 24 verbindet, ein Leerlaufstellungssignal (46) von Fahrpedal oder Drosselklappe und ein Sicherheitsanforderungssignal (48) zugeführt. Die Verbindungsleitung 50 stellt symbolisch einen Austausch von Daten zwischen Motorleistungssteuerung 24 und Motorsteuerungseinheit 22 dar, die in der jeweiligen Einheit zur Lösung ihrer Aufgabe benötigt werden.

Das elektronische Motorleistungssteuerungssystem 24 steht über seine Eingangsleitungen 52 und 54 bis 56 mit Meßanordnungen wie mit einem oder mehreren Drosselklappenpotentiometern 58 zur Bestimmung der Drosselklappenstellung, mit einer Einrichtung zur Messung der Fahrgeschwindigkeit 60 und/oder mit einem Leerlaufschalter 62 der Drosselklappe 14 in Verbindung. Ferner wird dem elektronischen Motorleistungssteuerungssystem 24 über ein oder mehrere Fahrpedalstellungspotentiometern 64 die Stellung des Fahrpedals 66 über die Eingangsleitung 68 zugeführt, sowie über die Eingangsleitung 70 ein Signal, das die Leerlaufstellung des Fahrpedals repräsentiert. In Abhängigkeit dieser Eingangssignale beeinflußt die elektronische Motorleistungssteuerung 24 über ihre Ausgangsleitung 72 und ihre Treiberstufe 74 die Stellung eines Stellelements 76, das über eine drehfeste Verbindung 78 mit der Drosselklappe 14 verbunden ist. Die Verbindungsleitungen 40 bis 42 zur Ansteuerung der Kraftstoffzumeßeinrichtungen 18 sind mit Rückmeldeleitungen 80 bis 82 verbunden, in denen sich als Dioden 84 bis 86 dargestellte Meßanordnungen befinden, die Funktion bzw. Ansteuerung der Kraftstoffzumeßeinrichtungen 18 erkennen und diese Information über die Eingangsleitungen 88 bis 90 der elektronischen Motorleistungssteuerung 24 zuführen. Der elektronischen Verbindung Fahrpedal 66 - Drosselklappe 14 kann auch eine in Figur 1 strichliniert dargestellte mechanische Verbindung 92 überlagert sein, die bei Ausfall der elektronischen Steuerung einen Notfahrbetrieb vornehmen kann.

Das hier dargestellte Ausführungsbeispiel anhand eines Otto-Motors beschränkt den Erfindungsgedanken nicht auf diesen Motorentyp. Bei Anwendung auf Dieselmotoren ist unter Drosselklappe 14 eine die Kraftstoffmenge steuernde Regelstange zu verstehen. Neben ihrer Steuerungsfunktion führt das elektronische Motorleistungssteuerungssystem 24 eine Funktionsüberprüfung seiner Komponenten und sich selbst nach aus dem Stand der Technik bekannten Vorgehensweisen durch. So wird z.B. entsprechend dem genannten Stand der Technik ein Fehler bei offenstehender Drosselklappe und Fahrpedal im Leerlaufposition erkannt. Weitere Fehlerquellen können u. a. die Potentiometer selbst oder die elektronische Ausrüstung des Steuersystems sein. Das elektronische Motorleistungssteuerungssystem 24 reagiert auf den erkannten Fehler durch Setzen des Sicherheitsanforderungssignals (48), das an die Motorsteuerungseinheit 22 abgegeben wird. Diese schaltet dann die Kraftstoffzufuhr zur Brennkraftmaschine mit höchster Priorität gegenüber ihren anderen Steuerfunktionen ab. Bevorzugt findet die Kraftstoffabschaltung oberhalb einer vorgegebenen Drehzahl, typischerweise 1000 - 2000 Umdrehungen/min. statt, während unterhalb dieser Drehzahl Kraftstoff zugeführt wird, um einen Notfahrbetrieb zu ermöglichen und die Zusatzaggregate betriebsfähig zu halten. Vorteilhaft, insbesondere bei Dieselmotoren, wäre es, statt Abschaltung eine Verringerung der Kraftstoffzufuhr auf eine vorgegebene Notfahrmenge vorzunehmen.

Eine Überwachung dieser Sicherheitsfunktion während des Betriebs der Brennkraftmaschine wird nun dadurch erreicht, daß die elektronische Motorleistungssteuerung 24 das Sicherheitsanforderungssignal (48) zu Testzwecken setzt. Die korrekte Durchführung der Sicherheitsanforderung kann das elektronische Motorleistungssystem 24 über die Verbindung 80 bis 82 überprüfen. Dabei sind die Endstufenausgänge bzw. die Ansteuerleitungen für die Zumeßeinrichtungen 18 mit den Eingängen 88 bis 90 der elektronischen Motorleistungssteuerung über eine sogenannte, durch die Dioden 84 bis 86 dargestellte wired-or-Verknüpfung verbunden. Darüber hinaus läßt sich in einer anderen vorteilhaften Ausführungsform auch der Signalverlauf in den Ansteuerleitungen überprüfen. Wird bei der Überprüfung eine fehlerhafte Sicherheitsfunktion festgestellt, bildet die elektronische Motorleistungssteuerung 24 über ihre Ausgangsleitung 73 ein Alarmsignal zum Auslösen einer geeigneten Fehlerreaktion. Diese Fehlerreaktion besteht vorzugsweise in einem mechanischen Notfahrbetrieb über die mechanische Verbindung 92, in einer Leistungsreduzierung durch Begrenzung des Drosselklappenwinkels oder in der in Fig. 1 beispielhaft eingezeichneten Warnlampe 75.

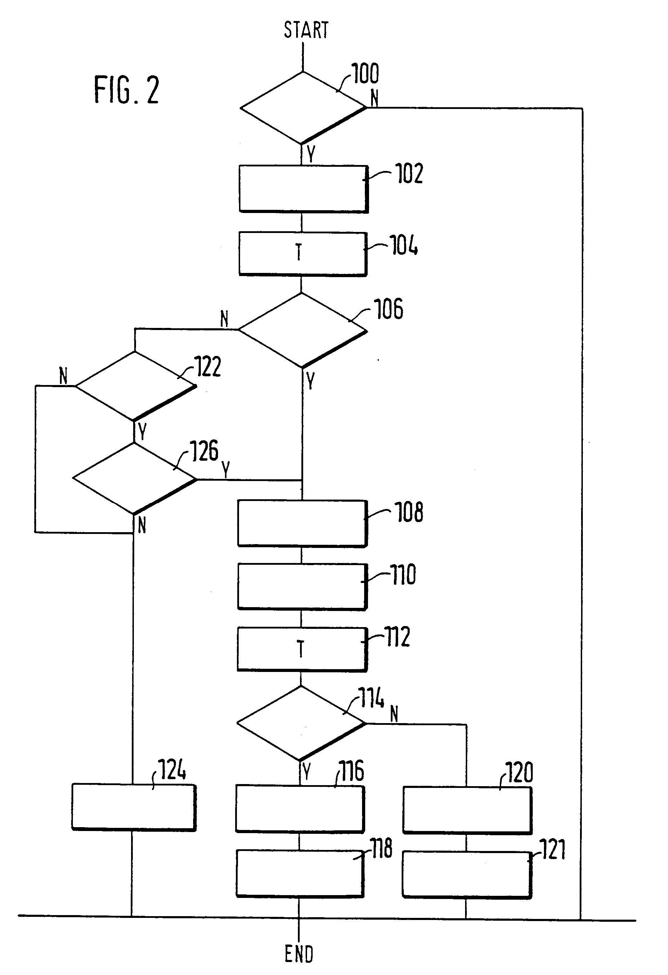

Vorzugsweise wird die Überprüfung der Sicherheitsfunktion während des Schubbetriebs durchgeführt, da in dieser Betriebsphase die Motorsteuerungseinheit 22 die aus dem Stand der Technik bekannte Schubabschaltung durchführt. Dadurch sind negative Einflüsse auf das Fahrverhalten bzw. den Fahrer ausgeschlossen. Die Schubbetriebsphase wird von der Motorsteuerungseinheit durch ein über die Verbindungsleitung 46 anliegendes Leerlaufstellungssignal, d.h. eines sich in Leerlaufstellung befindlichen Fahrpedals bzw. Drosselklappe, einer Drehzahlbedingung n n0 und ggf. in Abbhängigkeit weiterer Betriebsparameter der Brennkraftmaschine wie beispielsweise Motortemperatur erkannt. Findet die Sicherheitsanforderung während der Schubbetriebsphase statt, so ist eine eindeutige Zuordnung der Kraftstoffabschaltung zum Leerlaufstellungssignal oder dem Sicherheitsanforderungssignal durchzuführen, um eine eindeutige Überwachung der oben angesprochenen Sicherheitsfunktion zu gewährleisten. Diese Vorgehensweise wird zum besseren Verständnis anhand des Flußdiagramms in Figur 2 dargestellt.

Nach Start des in Figur 2 dargestellten, in der elektronischen Motorleistungssteuerung 24 ausgeführten Programmteils wird im Abfrageblock 100 überprüft, ob Fahrpedal bzw. Drosselklappe ihre Leerlaufposition eingenommen haben. Bei negativer Antwort wird der Programmteil beendet, während im positiven Fall das Leerlaufstellungssignal über die Verbindungsleitung 46 an die Motorsteuerungseinheit 22 abgegeben wird (102). Nach Ablauf einer vorgegebenen Reaktionszeit (104), die im wesentlichen von der Rechenzeit der Motorsteuerungseinheit 22 bestimmt wird, wird im Abfrageblock 106 überprüft, ob die Kraftstoffzufuhr abgeschaltet ist. Wird eine unterbrochene Kraftstoffzufuhr im Block 106 erkannt, so wird nach Block 108 die Sicherheitsanforderung gesetzt und im darauffolgenden Funktionsblock 110 das Leerlaufstellungssignal zurückgenommen. Nach Ablauf einer erneuten Reaktionszeit 112, wird erneut überprüft, ob die Kraftstoffzufuhr abgeschaltet ist oder nicht (Abfrageblock 114). Die bei einer funktionsfähigen Sicherheitsfunktion in Abfrageblock 114 festgestellte Kraftstoffabschaltung rührt entsprechend den Maßnahmen der Blöcke 108 und 110 vom Sicherheitsanforderungssignal her. D.h. in Block 116 kann somit festgestellt werden, daß die Sicherheitsfunktion in Ordnung ist und der Test erfolgreich beendet werden kann, indem das Leerlaufstellungssignal erneut gesetzt und die Sicherheitsanforderung zurückgenommen wird (118). Wird im Abfrageblock 114 Kraftstoffzumessung festgestellt, wird in Block 120 die Sicherheitsfunktion als fehlerhaft erkannt, in Block 121 ein Alarmsignal generiert und der Programmteil ebenfalls beendet.

Die Informationen, die den Entscheidungen in den Abfrageblöcken 106 und 114 zugrundeliegen, werden der elektronischen Motorleistungssteuerung 24 über die oben beschriebene wired-or-Verbindung und die Eingangsleitungen 88 bis 90 zugeführt.

Nach erkannter Leerlaufstellung (100 bis 104) kann in dem oben beschriebenen Abfrageblock 106 als zweite Möglichkeit festgestellt werden, daß dennoch Kraftstoff zugeführt wird. So wird im nicht zwangsläufig vorhandenen, aber vorteilhaften Block 122 abgefragt, ob seit dem letzten erfolgreichen Test eine vorgegebene Zeitspanne, z.B. 15 Minuten, vergangen sind. Ist dies nicht der Fall, so kann auf eine nähere Untersuchung verzichtet werden und der Test wird im Block 124 abgebrochen und der Programmteil beendet. Wird diese Zeitdauer seit dem letzten erfolgreichen Test jedoch überschritten, so wird über den Abfrageblock 126, der die momentane Motordrehzahl mit einer vorgegebenen Drehzahl z.B. 2000 Umdrehungen pro Minute vergleicht, trotz nicht abgeschaltetem Kraftstoff eine Überprüfung der Sicherheitsfunktion erzwungen. Dabei muß jedoch die Bedingung des Abfrageblocks 126, daß die Motordrehzahl größer als eine vorgegebene Schwelldrehzahl ist, erfüllt sein. Im anderen Fall wird der Test entsprechend Block 124 abgebrochen und das Programmteil beendet. Die vorgegebene Schwelldrehzahl des Abfrageblocks 126 entspricht einer unteren Sicherheitsdrehzahlschwelle, unterhalb der keine Kraftstoffabschaltung bzw. Kraftstoffabschaltung nur unter besonderen Bedingungen stattfinden kann, um ein sofortiges Ausgehen des Motors zu verhindern bzw. den Fahrkomfort nicht wesentlich zu verschlechtern.

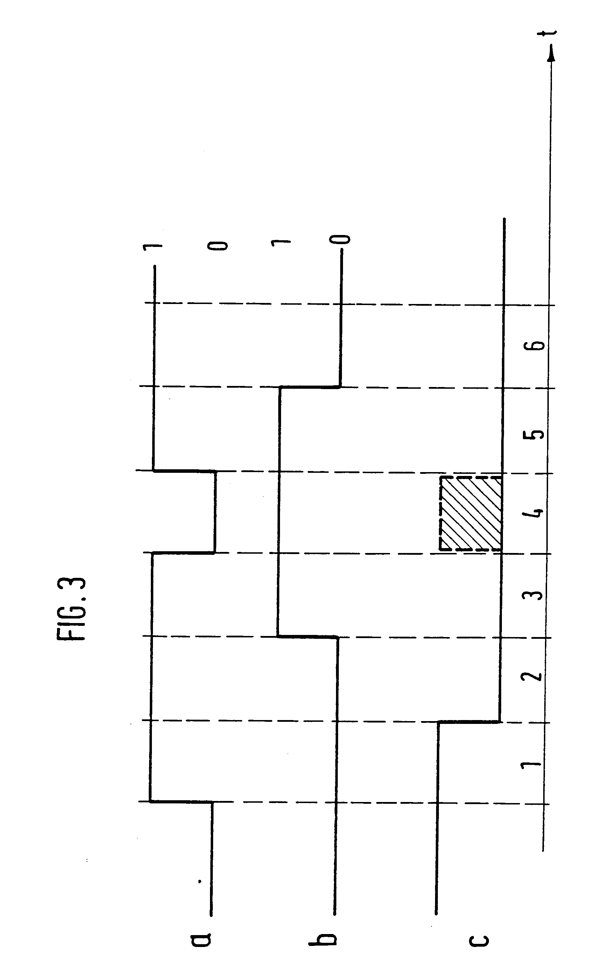

Eine weitere Verdeutlichung der erfindungsgemäßen Vorgehensweise wird durch das in Figur 3 dargestellte Zeitdiagramm erreicht. Dabei beschreibt Figur 3a den zeitlichen Signalverlauf des auf der Verbindungslinie 46 übermittelten Leerlaufstellungssignals, Figur 3b den Signalverlauf des auf Verbindungslinie 48 übermittelten Sicherheitsanforderungssignals und Figur 3c das Verhalten der Kraftstoffzumessung. In Zeitrichtung ist das Zeitdiagramm zum besseren Verständnis in sechs Phasen eingeteilt. Dabei wird Phase 1 gekennzeichnet durch das Auftreten des Leerlaufstellungssignals und dem Abschalten der Kraftstoffzufuhr nach einer vorgegebenen Reaktionszeit oberhalb einer Drehzahlschwelle, der sogenannten Abschneidedrehzahlschwelle. Diese Phase kennzeichnet den Beginn des Schubbetriebs. In Phase 2 erkennt die elektrische Motorleistungssteuerung 24 die erfolgte Abschaltung über ihre Eingänge 88 bis 90, während sie in Phase 3 das Signal "Sicherheitsanforderung" an die Motorsteuerungseinheit abgibt, um einen sicherheitskritischen Betriebszustand zu simulieren. In Phase 4 schließlich wird zum Überprüfen der Sicherheitsfunktion das Leerlaufstellungssignal von der elektronischen Motorleistungssteuerung 24 zurückgenommen und überprüft, ob der Kraftstoff aufgrund des Sicherheitsanforderungssignals weiterhin ausgeschaltet bleibt. In Phase 5 wird das Leerlaufsignal der elektronischen Motorleistungssteuerung gesetzt und nach Ablauf einer Reaktionszeit die Sicherheitsanforderung in Phase 6 zurückgenommen. Die Kraftstoffzufuhr bleibt nun aufgrund der Schubabschaltefunktion abgeschaltet. Das fehlerhafte Arbeiten der Sicherheitsfunktion wird dann erkannt, wenn in Phase 4 eine Zumessung des Kraftstoffs erfolgt (schraffiert).

Die Signalpegel der in Figur 3 dargestellten Zeitverläufe werden von digitalen 0-1-Signalen gebildet.

Löst die Sicherheitsfunktion keine Kraftstoffabschaltung, sondern lediglich eine Reduzierung aus, so ist in Phase 4 ein fehlerhaftes Arbeiten dann erkennbar, wenn die Kraftstoffzumessung uneingeschränkt erfolgt. In diesem Fall ist der Test der Sicherheitsfunktion nicht auf den Schubbetrieb begrenzt.

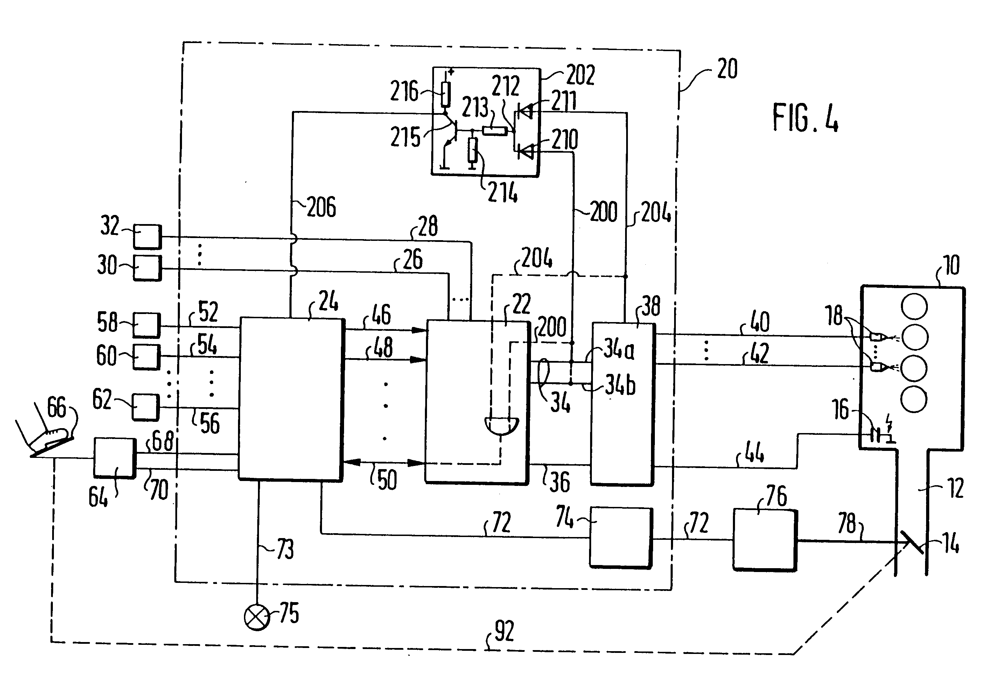

Figur 4 stellt weitere vorteilhafte Realisierungsformen des erfindungsgemäßen Gedankens dar. Aus Straffungsgründen wird im folgenden nicht mehr auf die bereits anhand Figur 1 ausführlich beschriebenen, in Figur 4 mit denselben Bezugszeichen gekennzeichneten Einzelelemente sowie auf die weiter oben aufgezeigte Funktion der Anordnung eingegangen. Die Erläuterungen zu Figur 4 beschränken sich somit auf die Unterschiede zum Ausführungsbeispiel nach Figur 1, die lediglich die Art der Informationrückführung zur elektronischen Motorleistungssteuerung 24 betreffen.

Die in Figur 1 von der Motorsteuereinheit 22 zu der Treiberstufe 38 führende, symbolisch dargestellte Ausgangsleitung 34 dient als Träger unterschiedlicher Information. Zum Beispiel fließt über die Leitung 34a Information über die Länge des benötigten Einspritzimpulses, während die Leitung 34b ein Abschalt- oder Resetsignal der Treiberstufe 38 zuführt, mit dessen Hilfe eine Kraftstoffabschaltung durchgeführt wird.

Zur Überwachung der oben dargestellten Sicherheitsfunktion ist es auch möglich, sich der Informationen der Ausgangsleitung 34 zu bedienen. Eine Leitung 200 verbindet die Leitungen 34 mit einem Element 202, alternativ (gestrichelt dargestellt) mit der Motorsteuereinheit 22. Die Leitung 200 übermittelt ein Signal, wenn die Motorsteuereinheit Kraftstoffabschaltung zur Ausführung bringt.

Ferner ist eine Leitung 204 vorhanden, die das Element 202 mit der Treiberstufe 38 verknüpft, die alternativ mit der Motorsteuereinheit 22 verbunden ist. Diese Leitung trägt ein Fehlersignal, das nach aus dem Stand der Technik bekannten Methoden gebildet wird und einen Fehlerzustand der Treiberstufe 38 wie Kurzschlüße oder Fehlfunktionen der Ventilansteuerungen meldet.

In der Motorsteuereinheit bzw. dem Element 202 werden die Leitungen 200 und 204 bzw. deren Signale logisch ODER verknüpft. Das Ergebnis dieser ODER-Verknüpfung in der Motorsteuereinheit 22 wird über die Datenaustauschleitung 50 der elektronischen Motorleistungssteuerung 24 zugeführt. Bei Anwendung des Elements 202 zur Verknüpfung der Leitungen 200 und 204 wird der elektonischen Motorleistungssteuerung 24 ein der logischen ODER-Verknüpfung entsprechendes Signal über die die beiden Einheiten (202 und 24) verbindende Leitung 206 zugeführt.

Setzt die elektonische Motorleistungssteuerung entsprechend dem erfindungsgemäßen Verfahren eine Sicherheitsanforderung (48), so kann sie anhand der ihr wie oben erläutert zugeführten Signale die Verfügbarkeit der Sicherheitsfunktion erkennen. Liegt während der gesetzten Sicherheitsanforderung an der Leitung 206 (alternativ 50) ein Signal an, so bedeutet dies, daß die Kraftstoffabschaltung nicht stattgefunden hat oder daß die Treiberstufe 38 einen Defekt aufweist. Die elektronische Motoeleistungssteuerung 24 erkennt daraus, daß die Sicherheitsfunktion nicht zu Verfügung steht und setzt über ihre Ausgangsleitung 73 ein Alarmsignal.

Eine Ausführungsform des Elements 202 wird im folgenden beschrieben. Die Leitungen 200 und 204 werden im Element 202 über zwei Dioden 210 und 211 geführt, deren Kathoden im Verbindungspunkt 212 zusammengeführt sind, an den außerdem ein Widerstand 213 angeschlossen ist. Der Widerstand 213 ist mit seinem anderen Ende mit einem Widerstand 214, der gegen Masse geschaltet ist verbunden. Ferner sind die Widerstände 213 und 214 mit der Basis eines Transistors 215 verknüpft, dessen Emitter mit Masse und dessen Kollektor mit der Leitung 206 und über einen weiteren Widerstand 216 mit der Betriebsspannung verbunden ist. Bei Anliegen eines Signal auf der Leitung 200 oder 204 ist eine oder beide Dioden 210 und 211 durchgeschaltet, womit der Transistor 215 ebenfalls durchgeschaltet ist und auf der Leitung 206 ein einen Fehlerzustand repräsentierendes Signal erscheint. Das Element 202 arbeitet somit als logisches ODER-Gatter.

## Patentansprüche

1. Verfahren zur Steuerung und/oder Regelung der Motorleistung einer Brennkraftmaschine eines Kraftfahrzeugs,
- mit elektronischer Übertragung des Fahrerwunsches auf ein Motorleistungsstellelement,
- wobei bei einem sicherheitskritischen Betriebszustand im Bereich der Steuerung und/oder Regelung eine Sicherheitsfunktion wirksam wird, welche auf die Kraftstoffzumessung in drehzahlverminderndem Sinne eingreift
- und eine Überprüfung der Sicherheitsfunktion unabhängig vom sicherheitskritischen Betriebszustand durch Auslösen der Sicherheitsfunktion in der Schubbetriebsphase bei vorliegenden Kraftstoffabschaltbedingungen vorgenommen wird,
- wobei die Kraftstoffabschaltung wenigstens auf der Basis eines das losgelassene Fahrpedal oder Motorleistungsstellelement kennzeichnenden Signals ausgelöst wird
- und zur Auslösung der Sicherheitsfunktion bei vorliegender Kraftstoffabschaltung dieses Signal durch ein die Sicherheitsfunktion anforderndes Signal ersetzt wird
- und die Sicherheitsfunktion dann als fehlerhaft erkannt wird, wenn trotz ausgelöster Sicherheitsfunktion Kraftstoff zugemessen wird ,
- bzw. dann, wennn die Sicherheitsfunktion nur eine Verminderung der zugemessenen Kraftstoffmenge zur Folge hat, ein fehlerhaftes Arbeiten der Sicherheitsfunktion durch eine uneingeschränkte Kraftstoffzumessung erkannt wird.

2. Verfahren nach Anspruch 1, dadurch gekennzeichnet, daß Kraftstoffabschaltung bei erkannter Leerlaufzustellung von Fahrpedal oder Motorleistungsstellelement und bei einer Drehzahl, die oberhalb einer vorgegebenen Drehzahlschwelle liegt, vorgenommen wird.

3. Verfahren nach Anspruch 1 bis 2, bestehend aus den Schritten:
Erkennen einer Leerlaufstellung,
Erkennen der abgeschalteten Kraftstoffzufuhr,
Auslösen der Sicherheitsfunktion,
Aufheben des Leerlaufstellungssignals,
Erkennen, ob Kraftstoffabschaltung infolge der Sicherheitsfunktion stattfindet,
Auslösen einer Fehlerreaktion bei stattfindender Kraftstoffzumessung.

4. Verfahren nach einem der vorhergehenden Ansprüche, dadurch gekennzeichnet, daß nach einer vorgegebenen Zeitdauer seit dem letzten erfolgreichen Test bei vorliegender Kraftstoffabschaltung die Sicherheitsfunktion bei zugemessenen Kraftstoff ausgelöst wird.

5. Verfahren nach Anspruch 3, dadurch gekennzeichnet, daß die Fehlerreaktion im Übergang auf mechanische Steuerung der Drosselklappe in einer Leistungsreduzierung der Brennkraftmaschine und/oder in Betätigung einer Warnlampe besteht.

6. Vorrichtung zur Steuerung und/oder Regelung der Motorleistung einer Brennkraftmaschine eines Kraftfahrzeugs,
- mit einem elektronischen Gaspedalsystem,
- mit einer Sicherheitseinrichtung zum Eingriff auf die Kraftstoffzumessung im drehzahlvermindernden Sinn bei erkanntem sicherheitskritischen Betriebszustand,
- mit Mittel zur Beeinflussung der Kraftstoffzufuhr,
- mit Überprüfungsmitteln für die Sicherheitsfunktion unabhängig vom sicherheitskritischen Betriebszustand durch Auslösen der Sicherheitsfunktion in der Schubbetriebsphase,
- mit Kraftstoffabschaltmittel im Schubbetrieb wenigstens auf der Basis eines das losgelassene Fahrpedal oder Motorleistungsstellelement kennzeichnenden Signals,
- wobei die Überprüfungsmittel zur Auslösung der Sicherheitsfunktion bei vorliegender Kraftstoffabschaltung dieses Signal durch ein die Sicherheitsfunktion anforderndes Signal ersetzen
- und die Sicherheitsfunktion dann als fehlerhaft erkennen, wenn trotz ausgelöster Sicherheitsfunktion Kraftstoff zugemessen wird
- bzw. die Überprüfungsmittel dann, wenn die Sicherheitsfunktion nur eine Verminderung der zugemessenen Kraftstoffmenge zur Folge hat, ein fehlerhaftes Arbeiten der Sicherheitsfunktion durch eine uneingeschränkte Kraftstoffzumessung erkennen.

7. Vorrichtung nach Anspruch 6, dadurch gekennzeichnet, daß das elektronische Gaspedalsystem zur Überprüfung der korrekten Funktion der Sicherheitseinrichtung mit den Kraftstoffzumeßmitteln durch eine wired-or-Verbindung bzw. logische Oder-Verbindung verknüpft ist.

## Claims

1. Process for the open-loop and/or closed-loop control of the engine output of an internal-combustion engine of a motor vehicle,
- with electronic transmission of the driver's requirement to an engine output actuating element,
- a safety function which intervenes in the fuel metering in a speed-reducing sense coming into effect in the region of the open-loop and/or closed-loop control in the event of a safety-critical operating state
- and a testing of the safety function being performed independently of the safety-critical operating state by triggering the safety function in the overrun operating phase if fuel cut-off conditions exist,
- the fuel cut-off being triggered at least on the basis of a signal characterising the released accelerator or engine output actuating element
- and, for triggering the safety function when there is a fuel cut-off, this signal being replaced by a signal requesting the safety function
- and the safety function being detected as defective if fuel is metered in spite of the triggered safety function
- or, whenever the safety function only has the consequence of reducing the metered quantity of fuel, defective operating of the safety function being detected by unrestricted fuel metering.

2. Process according to Claim 1, characterised in that fuel cut-off is performed in the event of the idling position of accelerator or engine output actuating element being detected and in the event of a speed which lies above a predetermined speed threshold.

3. Process according to Claim 1 to 2 [sic], comprising the steps:
detection of an idling position,
detection of cut-off fuel supply,
triggering of the safety function,
cancelling of the idling position signal,
detection whether fuel cut-off takes place on account of the safety function,
detection of an error response in the event of fuel metering taking place.

4. Process according to one of the preceding claims, characterised in that, after a predetermined period of time since the last successful test, with the fuel cut off, the safety function is triggered if fuel is metered.

5. Process according to Claim 3, characterised in that the error response takes the form of a transfer to mechanical control of the throttle valve of a speed reduction of the internal-combustion engine and/or of an activation of a warning light.

6. Apparatus for the open-loop and/or closed-loop control of the engine output of an internal-combustion engine of a motor vehicle,
- with an electronic accelerator system,
- with a safety device for intervening in the fuel metering in a speed-reducing sense in the event of a safety-critical operating state being detected,
- with means for influencing the fuel supply,
- with testing means for the safety function independently of the safety-critical operating state by triggering the safety function in the overrun operating phase,
- with fuel cut-off means in overrun operation, at least on the basis of a signal characterising the released accelerator or engine output actuating element,
- the testing means for triggering the safety function when there is a fuel cut-off replacing this signal by a signal requesting the safety function
- and the safety function being detected as defective if fuel is metered in spite of the triggered safety function
- or, whenever the safety function only has the consequence of reducing the metered quantity of fuel, the testing means detecting defective operating of the safety function by unrestricted fuel metering.

7. Apparatus according to Claim 6, characterised in that the electronic accelerator system for testing the correct functioning of the safety device is linked to the fuel metering means by a wired-OR connection or a logical OR connection.

## Revendications

1. Procédé pour la commande et/ou la régulation de la puissance du moteur à combustion interne d'un véhicule automobile,
- avec transmission électronique du désir du conducteur à un élément de réglage de la puissance du moteur,
- tandis que dans le cas d'un état de fonctionnement critique pour la sécurité, dans le domaine de la commande et/ou de la régulation, une fonction de sécurité devient agissante et intervient sur le dosage du carburant dans le sens de la diminution de la vitesse de rotation,
- et il est procédé à une vérification de la fonction de sécurité indépendamment de l'état de fonctionnement critique pour la sécurité par déclenchement de la fonction de sécurité dans la phase de fonctionnement en poussée et en présence de conditions de coupure de l'alimentation en carburant,
- tandis que la coupure d'alimentation en carburant est déclenchée au moins sur la base d'un signal caractérisant une absence d'intervention sur la pédale d'accélérateur ou l'élément de réglage de la puissance du moteur,
- et pour le déclenchement de la fonction de sécurité alors que l'alimentation en carburant est coupée, ce signal est remplacé par un signal demandant la fonction de sécurité,
- et la fonction de sécurité est alors reconnue comme défectueuse lorsque, malgré le déclenchement de cette fonction de sécurité, le carburant est dosé,
- ou bien lorsque la fonction de sécurité n'a pour conséquence qu'une réduction de la quantité de carburant dosée, un fonctionnement défectueux de la fonction de sécurité est reconnu du fait d'un dosage illimité du carburant.

2. Procédé selon la revendication 1, caractérisé en ce que la coupure de l'alimentation en carburant est entreprise lorsqu'est détecté le positionnement au ralenti de la pédale d'accélérateur ou bien de l'élément de réglage de la puissance du moteur et pour une vitesse de rotation qui se situe au-dessus d'un seuil de vitesse de rotation prédéfini.

3. Procédé selon la revendication 1 ou 2, comportant les étapes :
reconnaissance d'un positionnement au ralenti,
reconnaissance de la coupure de l'alimentation en carburant,
déclenchement de la fonction de sécurité,
suppression du signal de positionnement au ralenti,
reconnaître si la coupure de l'alimentation en carburant a lieu du fait de la fonction de sécurité,
déclenchement d'une réaction de défaut si le dosage du carburant a lieu.

4. Procédé selon une des précédentes revendications, caractérisé en ce que, après un laps de temps prédéfini, depuis le dernier essai couronné de succès en présence d'une coupure de l'alimentation en carburant, la fonction de sécurité est déclenchée s'il y a dosage du carburant.

5. Procédé selon la revendication 3, caractérisé en ce que la réaction de défaut consiste dans le passage à une commande mécanique du clapet d'étranglement, en une réduction de la puissance du moteur à combustion interne et/ou dans l'actionnement d'une lampe d'avertissement.

6. Dispositif pour la commande et/ou la régulation de la puissance du moteur à combustion interne d'un véhicule automobile,
- avec un système électronique de la pédale d'accélérateur,
- avec un dispositif de sécurité pour intervenir sur le dosage de carburant dans le sens d'une diminution de la vitesse de rotation lorsqu'un état de fonctionnement critique pour la sécurité est détecté,
- avec des moyens pour influencer l'alimentation en carburant,
- avec des moyens de vérification pour la fonction de sécurité, indépendamment de l'état de fonctionnement critique pour la sécurité par déclenchement de la fonction de sécurité dans la phase de fonctionnement en poussée,
- avec un moyen de coupure de l'alimentation en carburant dans le fonctionnement en poussée, au moins sur la base d'un signal caractérisant la non intervention sur la pédale d'accélérateur ou l'élément de réglage de la puissance du moteur,
- tandis que les moyens de vérification pour le déclenchement de la fonction de sécurité en présence d'une coupure de l'alimentation en carburant, remplacent ce signal par un signal demandant la fonction de sécurité,
- et ils reconnaissent comme défectueuse la fonction de sécurité lorsque, malgré le déclenchement de cette fonction, du carburant est dosé,
- ou bien, lorsque la fonction de sécurité n'a pour conséquence qu'une diminution de la quantité de carburant dosée, les moyens de vérification reconnaissent un fonctionnement défectueux de la fonction de sécurité du fait d'un dosage de carburant illimité.

7. Dispositif selon la revendication 6, caractérisé en ce que le système électronique de la pédale d'accélérateur pour la vérification du fonctionnement correct du dispositif de sécurité, est combiné avec les moyens de dosage du carburant par une combinaison wired-or ou bien par une combinaison logique OU.
